Europäisches Patentamt

European Patent Office

Office européen des brevets

(11) Publication number: **0 157 047**
A2

# EUROPEAN PATENT APPLICATION

(21) Application number: 84307708.2

(22) Date of filing: 08.11.84

(51) Int. Cl.⁴: **H 01 S 3/096**, H 01 S 3/103

(30) Priority: 27.03.84 US 593779

(43) Date of publication of application: 09.10.85 Bulletin 85/41

(84) Designated Contracting States: **DE FR GB NL**

(71) Applicant: **OPTICAL STORAGE INTERNATIONAL - US, 8100-34th Avenue South, Minneapolis Minnesota 55440 (US)**

(72) Inventor: **Bracht, Roger Russell, 1235 Osgood Road, Colorado Springs Colorado (US)**
Inventor: **Silvey, Dorrel Robert, 12790 Pommel Circle, Elbert Colorado (US)**

(74) Representative: **Caro, William Egerton et al, J. MILLER & CO. Lincoln House 296-302 High Holborn, London WC1V 7JH (GB)**

(54) Method of and driver circuit for controlling a laser diode.

(57) A driver circuit for controlling a laser diode in response to a digital input signal, said driver circuit includes: a switching circuit (18, 24) for receiving a digital input signal (14) having a high voltage level and a low voltage level, said switching circuit, in operation, generating a switching output comprising a first switching voltage level in response to the high voltage level and a second switching voltage level responsive to the low voltage level. An emitter follower (36) has as its input the switching output for generating an emitter follower output comprising a first follower output voltage level in response to the first switching voltage level and a second follower output voltage level in response to the second switching voltage leve. A VMOS field effect transistor (42) has a gate connected to said emitter follower (36) so that, in operation, the voltage level at the gate is substantially equal to the voltage level of the output of the emitter follower, and has a source biased to a pre-selected source voltage. The VMOS field effect transistor (42) is in operation, enabled whenever the voltage level at the gate is substantially greater than the source voltage, and disabled when the voltage level at the gate is not substantially greater than the source voltage, one of the first and second follower output voltage levels being substantially greater than the source voltage and the other of said follower output voltage levels being no greater than a voltage level near the source voltage. A laser diode (12) is connected in series with the VMOS field effect transistor for emitting light whenever the VMOS field effect transistor is enabled.

# METHOD OF AND DRIVER CIRCUIT FOR CONTROLLING A LASER DIODE

This invention relates to methods of and driver circuits for controlling laser diodes.

Optical recording involves the use of a light source such as a laser diode to "write" information on an optical disk, usually by locally altering the disk surface to form a spot or hole which subsequently can be sensed by a reduced power laser in "reading" the information placed on the disk. As is the case with magnetic recording and other information processing techniques, the ever-present goal in optical recording is to increase the speed at which data can be written and read. A significant challenge encountered in optical data storage is the need for an effective means to force a laser diode to respond rapidly to incoming digital data.

One approach to this problem is shown in U.S. Patent Specification No. 4,027,179. A carrier-injected avalanche device causes an injection laser to emit light responsive to signals from a pulse generator. An offset voltage is provided by a capacitor through a resistor, rapidly to deplete any electric field caused by accumulation of electrons and holes at a control junction between semiconductor layers 14, 12 of the avalanche device. This enables a higher pulse repetition rate in the injection laser.

In U.S. Patent Specification No. 4,295,226 the junction depletion layer of a light emitting diode (LED) is depleted when a transistor is enabled, thus to provide a positive current overdrive to the LED. U.S. Patent Specification No. 4295226 further teaches a non-zero "off" state for current to the LED. Reduction of the current to zero then provides a negative overdrive effect without actually reverse biasing the diode. Pre-biasing of a field effect transistor (FET) is shown in U.S. Patent Specification No. 4,243,951. The pre-biasing produces a current in FET just below the "lasing" level of a laser diode. Such pre-biasing reduces the time for the laser diode to respond to the high-going pulse of a digital signal.

The present invention seeks to provide a simple, low-cost method of driver circuit for rapidly activating and deactivating a laser diode in response to a digital signal, to achieve such response in a laser diode through a coaxial cable with a minimum loss of speed even at high current requirements with minimum impact on adjacent circuitry, and to produce rapid response in a laser diode without prebiasing it and without a separate circuit for depleting a junction between semiconductor layers.

According to one aspect of the present invention there is provided a driver circuit for controlling a laser diode in response to a digital input signal, said driver circuit characterised by including: a switching means for receiving a digital input signal having a high voltage level and a low voltage level, said switching means, in operation, generating a switching output comprising a first switching voltage level in response to said high voltage level and a second switching voltage level responsive to said low voltage level; an emitter follower means having as its input said switching output for generating an emitter follower output comprising a first follower output voltage level in response to said first switching voltage level and a second follower output voltage level in response to said second switching voltage level; a VMOS field effect transistor having a gate connected to said emitter follower means so that, in operation, the voltage level at said gate is substantially equal to the voltage level of the output of said emitter follower means, and having a source biased to a pre-selected source voltage, said VMOS field effect transistor being, in operation, enabled whenever the voltage level at said gate is substantially greater than said source voltage, and disabled when the voltage level at said gate is not substantially greater than said source voltage, one of said first and second follower output voltage levels being substantially greater than said source voltage and the other of said follower output voltage levels being no greater than a voltage level near said source voltage; and a laser diode connected in series with said VMOS field effect transistor for emitting light whenever said VMOS field effect transistor is enabled.

Preferably the switching means includes first and second switching transistors, said first transistor being arranged to receive at its base said digital input signal, said second switching transistor being arranged to receive at its base a preselected voltage between said high and low voltage levels of said digital input signal, the voltage level at the emitters of said switching transistors being such that, said first switching transistor is forward biased whenever said digital input signal is low voltage level and is reverse biased whenever said digital input signal is high voltage level, and said second switching transistor is forward biased whenever said digital input signal is high voltage level and reverse biased whenever said digital input signal is low voltage level, the voltage level at the collector of said second switching transistor being said switching output.

The emitter follower means may include first and second follower transistors connected in series between first and second reference voltage levels, the input to the bases of said follower transistors being said switching output and the reference voltage levels being selected such that, in operation, said first switching voltage level forward biases said first follower transistor and reverse biases said second follower transistor, and said second switching voltage level reverse biases said first follower transistor, and forward biases said second follower transistor.

Preferably, the first follower transistor is an NPN transistor with its collector, in operation, maintained at said first reference voltage level, and the second follower transistor is a PNP transistor with its collector, in operation, maintained at said second reference voltage level, the voltage level at the emitters of said follower transistors comprising the output of the emitter follower means.

The follower transistors, in response to the signal from the switching means, positively drive the VMOS field effect transistor in both the "on" and "off" directions. The hard drive in both directions eliminates the need for pre-biasing of the laser diode since the VMOS field effect transistor rapidly responds to the hard drive to cause the diode to emit light rapidly in response to the high-going signal, and to quickly cease emitting in response to the low-going digital signal. The driver circuit can rapidly drive the laser diode through a relatively long coaxial cable and remain cool even under high current conditions.

According to another aspect of the present invention there is provided a method for controlling a laser diode in response to a digital input signal, said method characterised by including the steps of: providing a switching means for receiving a digital input signal, said digital signal having a high voltage level and a low voltage level, and generating, as the output of said switching means, a first switching voltage level in response to said high voltage level and a second switching voltage level responsive to said low voltage level; providing an emitter follower means having as its input the output of said switching means and generating, as the output of said emitter follower means, a first follower output voltage level in response to said first switching voltage level and second follower output voltage level in response to said second switching voltage level; providing a VMOS field effect transistor and connecting the gate of said field effect transistor to said emitter follower means whereby the voltage level at the gate is substantially equal to the level of said emitter follower means output, and maintaining the source of said VMOS field effect transistor at a preselected source voltage, said VMOS field effect transistor being enabled whenever said gate voltage level is substantially greater than said source voltage, and disabled when the gate voltage is not substantially greater than said source voltage, one of said first and second follower output voltage levels being substantially greater than said source voltage and the other of said follower output voltage levels being no greater than a level near said source voltage; and connecting a laser diode in series with said field effect transistor.

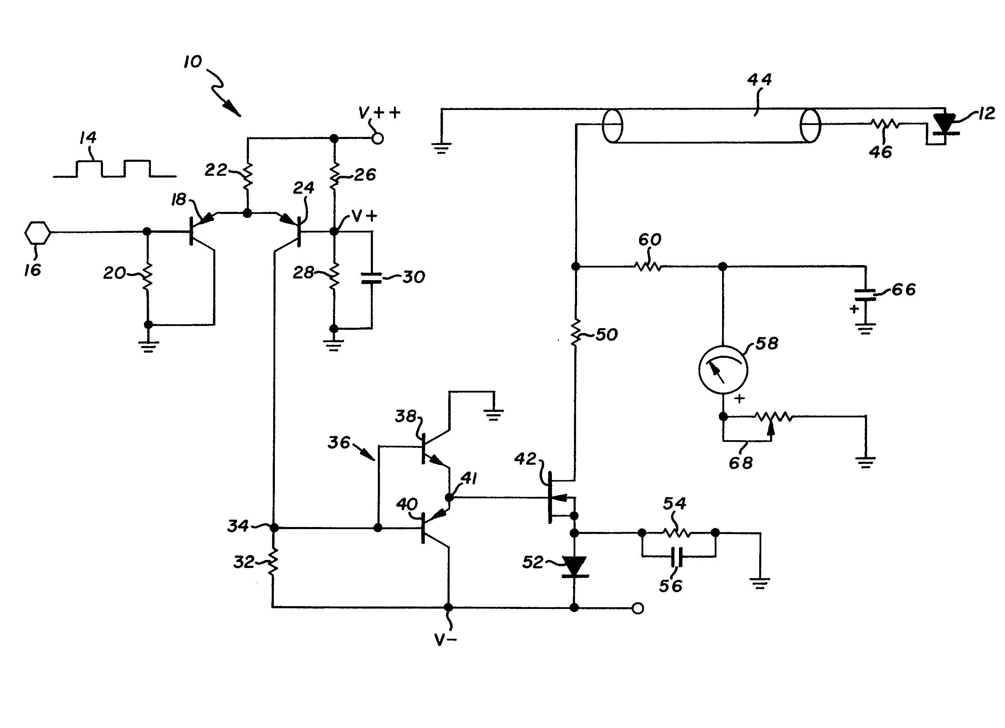

The invention is illustrated, merely by way of example, in the accompanying drawing which is a circuit diagram of one embodiment of a driver circuit 10 according to the present invention for controlling a laser diode 12.

The driver circuit 10 controls the operation of the laser diode 12 in response to an incoming digital data signal 14. The signal 14 typically is a digital input signal compatible with transistor-transistor logic (TTL) having a "high" level of five volts and a "low" value of zero volts or ground potential.

The signal 14 is received at an input node 16 of the driver circuit 10 and applied to the base terminal of a PNP switching transistor 18. The collector of the transistor 18 is connected to ground. The signal 14 also is terminated to ground through a resistor 20. This resistor also maintains the base input of the transistor 18 at a low level if there is no digital input. The required first stage switching current is supplied from a positive voltage source V++ through a resistor 22 to the emitter of the transistor 18 and the emitter of a second PNP switching transistor 24. The voltage source V++ is also connected to ground through first and second voltage setting resistors 26, 28 in series between the voltage source V++ and ground. Between the resistors 26, 28 is a connection to the base of the transistor 24. The resistors 26, 28 are selected such that an intermediate positive reference voltage V+ is continually applied to the base of the transistor 24. A capacitor 30 is connected between the base of the transistor 24 and ground, in parallel with the resistor 28, thus minimising the effect of AC signal components at the base of the transistor 24.

The transistors 18, 24, in cooperation with the resistors 20, 22, 26, 28, comprise a switching means in which one or the other of the transistors conducts current, depending upon the level of the signal 14. Specifically in response to a signal level of zero volts in the signal 14, the transistor 18 is forward biased and the majority of current due to voltage source V++ is conducted through resistor 22 and the transistor 18 to ground. As a result, a low positive voltage is produced at the emitters of the transistors 18, 24, maintaining the transistor 18 in a forward biased condition but reverse biasing the transistor 24 since the emitter voltage is less than the collector voltage, namely the reference voltage V+. It follows that, since most of the current is conducted through the resistor 22 and the transistor 18 to ground, there is negligible current through the transistor 24 and the voltage resulting at the collector of the transistor 24 will be nearly equal to the level at a negative voltage source V-.

Should the high signal level of the signal 14 be received at the node 16, the increased voltage level immediately reverse biases the transistor 18 so that it ceases to conduct current. The voltage level at the emitter inputs to the transistors 18, 24 consequently is forced upward and, as the base input to the transistor 24 is at the reference voltage V+ which is lower than the voltage of the voltage source V++, it is this transistor which now becomes forward biased, thus to conduct the majority of current generated due to the voltage source V++ through itself, the resistor 22 and a resistor 32 to the negative voltage source V-.

Between the transistor 24 and a resistor 32 is a node 34 which serves as the input to a dual emitter follower 36 including a first follower transistor 38 and a second follower transistor 40 in series between two reference voltage levels: ground and voltage of the voltage source V-. The transistor 38 is an NPN transistor having its collector connected to ground, whilst a PNP transistor 40, has its collector connected to the voltage source V-. The signal at the node 34 is an input to the bases of both transistors 38, 40. As later explained, the level of the signal at the node 34 determines which of the transistors 38, 40 is conductive, and the level at the node is itself responsive to whether or not the transistor 24 is conducting current. The transistors 38, 40 provide sufficient drive to isolate VMOS gate capacitance from the high speed switching current.

Linked to the emitters of the transistors 38, 40 is a node 41 which also is the gate input to an enhancement mode VMOS FET (very high current metal oxide semiconductor field effect transistor) 42. The FET 42 is connected in series with the laser diode 12. The laser diode 12 is connected to ground through a coaxial cable 44. A resistor 46 provides a matching impedance. A resistor 50 provides a selected resistance for setting the maximum current to be switched through the laser diode 12. The source terminal of the FET 42 is connected to the voltage source V- through a diode 52, and further is connected to ground through a resistor 54 and capacitor 56 connected in parallel which act as a current sink to reduce the effect of current surges. Being of the enhancement mode type, the FET 42 is enabled whenever the gate-to-source voltage is positive and is non-conductive whenever the gate-to-source potential difference is at or near zero.

The driver circuit 10 operates as follows: when the incoming signal 14 is at its low level, the transistor 18 conducts while the transistor 24 is reverse biased and therefore non-conductive. Consequently, the voltage level at the node 34, which is the input to the emitter follower 36, is approximately at the low voltage level of the voltage source V-. This reverse voltage biases the transistor 38 to prevent flow of current through it. Concurrently, the low voltage level at the node 34 forward biases the transistor 40 to conduct current through the transistor 40 should the voltage level at the node 41 be higher than the voltage level of the voltage source V-. As the connection to the voltage source V- through the diode 52 maintains the voltage at the source of the FET 42 at or near the voltage level of the voltage source V-, FET 42 is non-conductive.

When the level of the signal 14 becomes high level, the transistor 18 is reverse biased, and the transistor 24 becomes conductive as previously explained. In response to conduction from the voltage source V++, the voltage at the node 34 is instantaneously forced upward to a significantly higher voltage level than the voltage source V-. The increased voltage at the node 34 immediately forward biases the transistor 38 and reverse biases the transistor 40, and the newly opened conductive path through the transistor 38 rapidly brings the voltage level at the node 41, the gate of FET 42, upward from its prior level, approximately to the voltage level of the voltage source V-.

A characteristic of the enhancement mode VMOS FET 42 is a low capacitance between the gate and drain, and a high capacitance between its gate and source. It is the rapid increase in gate voltage, brought about by the transistor 38 connected to ground, which enables a sufficiently rapid voltage increase to turn on the FET 42 "hard", thus to enable current through the FET 42 and the laser diode 12 causing it to emit light in accordance with the rise to the high level in the signal 14.

In response to the signal 14 going low, the driver circuit 10 rapidly deactivates the laser diode 12. As the incoming signal returns to its low level, the transistor 18 becomes forward biased, thus to draw most of the current generated at the voltage source V++ through it to ground. This reduces the voltage at the emitter of the transistor 24, thus to reverse bias it and cut off the current from the voltage source V++ to the voltage source V-. In the absence of current through the transistor 24, the voltage source V- rapidly pulls the voltage at the node 34 downward toward the voltage level of the voltage source V-, thus to reverse bias and disable the transistor 38 while forward biasing the transistor 40. The forward biasing of the transistor 40, in closing the circuit between the node 41 and the voltage source V-, rapidly reduces the voltage at the gate of the FET to approximately the voltage level of the voltage source V-, thus to turn off the FET 42 "hard".

The resistor 54 and the capacitor 56, connected in parallel between the source of the FET 42 and ground, tend to filter AC components and prevent surge currents from propogating to other adjacent circuitry. Circuitry for monitoring the read level current applied through the laser diode 12 includes a meter 58 connected to the laser diode through a resistor 60. This circuitry may or may not be required. A potentiometer 68 connects the meter 58 to ground and is adjustable to accommodate the laser current and meter reading level. A capacitor 66 is connected to ground in parallel with the meter and potentiometer and acts as a filter.

In the preferred embodiment compatible with transistor/transistor logic (TTL), the following values for components have been found satisfactory:

|                |                |
|----------------|----------------|
| Resistor 20    | 56 ohms        |
| Resistor 22    | 82 ohms        |
| Resistor 26    | 330 ohms       |
| Resistor 28    | 220 ohms       |
| Capacitor 30   | 0.1 microfarad |

In specific applications, the resistor 20 may be other than 56 ohms, as it is selected to match the impedance of the incoming signal 14. The voltage source V++ is preferably at +5 volts, while the voltage source V- is at -24 volts. This voltage source should be variable to allow write power adjustment. The resistor 32 between the voltage sources is preferably 470 ohms.

The resistor 50 is 22 ohms. The resistor 46 is 47 ohms and with a resistance of the diode laser of approximately 3 ohms, balances the resistance of the coaxial cable 44 of 50 ohms. The capacitor 56 connected to the source of the FET 42 is one microfarad while the resistor 54 is 1K ohms. The resistor 60 is 220 ohms, the potentiometer 66 is approximately 1K ohms, whilst the capacitor 66 is 10 microfarads.

The components of the driver circuit 10, particularly the switching means, can readily be adjusted for compatability with emitter coupled logic (ECL). For the signal 14, ECL values are a high level signal of -0.8 volts and the low level signal of -1.8 volts. Also, the incoming signal is terminated through the resistor 20 to -2 volts rather than to ground. The values for the switching means components will then be as follows:

|                |            |
|----------------|------------|
| V++ biased to  | -1.2 volts |
| Resistor 20    | 100 ohms   |
| Resistor 22    | 200 ohms   |

The driver circuit 10 rapidly and positively controls current through the laser diode in response to an input digital data signal.

0157047

The hard drive characteristic of the emitter follower, both in enabling and disabling the VMOS FET, eliminates the need for maintaining a low "steady state" current in the diode laser, thus to increase its life and eliminate the problem of distinguishing between low level and high level light emission from the laser diode.

In addition, the driver circuit allows high currents to be very rapidly switched through an interconnecting coaxial cable to control a laser diode. The driver circuit remains relatively cool and minimises current surges that could otherwise adversely affect associated circuitry.

-11-

CLAIMS

1. A driver circuit for controlling a laser diode in response to a digital input signal, said driver circuit characterised by including: a switching means (18,24) for receiving a digital input signal (14) having a high voltage level and a low voltage level, said switching means, in operation, generating a switching output comprising a first switching voltage level in response to said high voltage level and a second switching voltage level responsive to said low voltage level; an emitter follower means (36) having as its input said switching output for generating an emitter follower output comprising a first follower output voltage level in response to said first switching voltage level and a second follower output voltage level in response to said second switching voltage level; a VMOS field effect transistor (42) having a gate connected to said emitter follower means (36) so that, in operation, the voltage level at said gate is substantially equal to the voltage level of the output of said emitter follower means, and having a source biased to a pre-selected source voltage, said VMOS field effect transistor (42) being, in operation, enabled whenever the voltage level at said gate is substantially greater than said source voltage, and disabled when the voltage level at said gate is not substantially greater than said source voltage, one of said first and second follower output voltage levels being substantially greater than said source voltage and the other of said follower output voltage levels being no greater than a voltage level near said source voltage; and a laser diode (12) connected in series with said VMOS field effect transistor for emitting light whenever said VMOS field effect transistor is enabled.

2. A driver circuit as claimed in claim 1 characterised in that, in operation, said first follower output voltage level is substantially greater than said source voltage.

3. A driver circuit as claimed in claim 1 or 2 characterised in that switching means includes first and second switching transistors (18, 24) said first transistor (18) being arranged to receive at its base said digital input signal (14), said second switching transistor (24) being arranged to receive at its base a preselected voltage between said high and low voltage levels of said digital input signal, the voltage level at the emitters of said switching transistors being such that, said first switching transistor (18) is forward biased whenever said digital input signal (14) is low voltage level and is reverse biased whenever said digital input signal is high voltage level, and said second switching transistor is forward biased whenever said digital input signal is high voltage level and reversed biased whenever said digital input signal is low voltage level, the voltage level at the collector of said second switching transistor being said switching output.

4.   A driver circuit as claimed in claim 3 characterised by including a switching voltage source (V++) connected, through a resistor (22), for providing the voltage level at the emitters of said switching transistors.

5.   A driver circuit as claimed in claim 4 characterised in that the voltage level at said switching voltage source (V++) is, in operation, substantially equal to said high voltage level.

6.   A driver circuit as claimed in any of claims 3 to 5 characterised in that each of the switching transistors (18, 24) is a PNP transistor.

7.   A driver circuit as claimed in any preceding claim characterised in that said emitter follower means (36) includes a first follower transistor (38) and a second follower transistor (40) connected in series between first and second reference voltage levels, the input to the bases of said follower transistors being said switching output and the reference voltage levels being selected such that, in operation, said first switching voltage level forward biases said first follower transistor (38) and reverse biases said second follower transistor, (40), and said second switching voltage level reverse biases said first follower transistor (38), and forward biases said second follower transistor (40).

8.   A driver circuit as claimed in claim 7 characterised in that the first follower transistor (38) is an NPN transistor with its collector, in operation, maintained at said first reference voltage level, and the second follower transistor (40) is a PNP transistor with its collector, in operation, maintained at said second reference voltage level, the voltage level at the emitters of said follower transistors comprising the output of the emitter follower means.

9.   A method for controlling a laser diode in response to a digital input signal, said method characterised by including the steps of: providing a switching means (18, 24) for receiving a digital input signal, said digital signal having a high voltage level and a low voltage level, and generating, as the output of said switching means (18, 24), a first switching voltage level in response to said high voltage level and a second switching voltage level responsive to said low voltage level; providing an emitter follower means (36) having as its input the output of said switching means (18, 24) and generating, as the output of said emitter follower means (36), a first follower output voltage level in response to said first switching voltage level and second follower output voltage level in response to said second switching voltage level; providing a VMOS field effect transistor (42) and connecting the gate of said field effect transistor to said emitter follower means (36) whereby the voltage level  at the gate is substantially equal to the level of said emitter follower means output, and maintaining the source of said VMOS field effect transistor at a preselected source voltage, said VMOS field effect transistor being enabled whenever said gate voltage level is substantially greater than said source voltage, and disabled when the gate voltage is not substantially greater than said source voltage, one of said first and second follower output voltage levels being substantially greater than said source voltage and the other of said follower output voltage levels being no greater than a level near said source voltage; and connecting a laser diode (12) in series with said field effect transistor.

0157047